# FASCICULE DE BREVET EUROPEEN

(11) **EP 0 537 062 B1**
(45) Date de publication et mention de la délivrance du brevet: **14.08.1996**
(21) Numéro de dépôt: 92402723.8
(22) Date de dépôt: 06.10.1992
(51) Int. Cl.: C23C 16/26, C23C 16/02, C23C 8/80

(54) **Procédé de traitement pour déposer une couche de carbone en phase vapeur sur la surface d'une pièce métallique**
Verfahren zur Dampfabscheidung eine Kohlenstoffschicht auf die Oberfläche eines Metallsubstrates
Treatment method for vapor deposition of a carbon layer on the surface of a metallic substrate

(30) Priorité: 07.10.1991 FR 9112322
(43) Date de publication de la demande: 14.04.1993
(73) Titulaire: NITRUVID, 95100 Argenteuil (FR)
(72) Inventeur: Cellier, François, F-42700 Firminy (FR); Nowak, Jean-François, F-42000 Saint-Etienne (FR); Choquet, Patrick, F-42100 Saint-Etienne (FR)
(74) Mandataire: Polus, Camille

(56) Documents cités:
- EP-A- 0 403 986
- WO-A-90/04044
- DE-A- 3 939 809
- GB-A- 979 467
- US-A- 4 414 085
- PATENT ABSTRACTS OF JAPAN vol. 14, no. 334 (C-742)(4277) 18 Juillet 1990 & JP-A-2122075
- PATENT ABSTRACTS OF JAPAN vol. 12, no. 444 (C-545)(3291) 22 Novembre 1988 & JP-A-63166970
- JOURNAL OF VACUUM SCIENCE AND TECHNOLOGY A vol. 5, no. 6, 1 Novembre 1987, NEW YORK , USA pages 3287 - 3312 , XP99611 HSIAO-CHU TSAI ET AL. 'CHARACTERIZATION OF DIAMONDLIKE CARBON FILMS AND THEIR APPLICATION AS OVERCOATS ON THIN-FILM MEDIA FOR MAGNETIC RECORDING'

## Description

La présente invention concerne un procédé de traitement pour déposer une couche de carbone, en phase vapeur, dans une enceinte, sur la surface d'une pièce métallique pour conférer à cette pièce une résistance à l'usure par frottement, une résistance à la corrosion, ainsi qu'une coloration.

On connaît des procédés d'élaboration d'une couche mince de carbone dur amorphe, appelée carbone I-C, déposée sur des substrats afin de leur conférer des propriétés tribologiques et de résistance à la corrosion améliorées.

Ces procédés sont tous des procédés de dépôt sous vide ou à basse pression, généralement à l'aide d'un plasma pour décomposer et ioniser les espèces réactives utilisées.

Le développement industriel de couches de carbone dur amorphe est limité principalement en raison des problèmes d'adhérence rencontrés, notamment, lorsqu'elles sont déposées directement sur des substrats métalliques comme par exemple des aciers.

Une voie possible, pour augmenter les propriétés d'adhérence de la couche de carbone consiste à réaliser une couche intermédiaire dans le but d'ajuster les coefficients de dilatation thermique linéaire. On peut citer également un procédé décrit dans FR-A-2 596 775 conduisant, sur un substrat d'acier, à réaliser successivement une couche de TiN suivie d'une couche de Ti(CN) puis une couche de carbone I-C par évaporation thermique à l'aide de plasma. Toutefois la mise en oeuvre du procédé est difficile et son caractère directif ne permet pas de traiter de façon homogène les surfaces de pièces présentant des géométries complexes et/ou de grandes dimensions.

DE-A-3 939 809 décrit un procédé de fabrication d'un outil pour le travail du bois, dont la surface est rendue plus dure par (1) un traitement durcisseur par nitruration, carbonitruration ou carburation puis (2) dépôt sur la surface durcie d'une couche de matériau dur distincte.

L'invention a pour but de pallier de tels inconvénients en proposant un procédé de dépôt de carbone adhérent sur des pièces métalliques, conférant auxdites pièces une résistance à l'usure par frottement, à la corrosion ainsi qu'une coloration.

L'invention a pour objet un procédé dans lequel :
a) - on soumet la surface de la pièce à un traitement préalable thermochimique sous plasma électrique dans l'enceinte sous atmosphère contenant de l'hydrogène et au moins une espèce réactive choisie parmi N₂, CH₄, C₃H₈ et H₂S, à une température comprise dans l'intervalle [350 - 900]° C, la pression de l'atmosphère de l'enceinte étant comprise dans un intervalle de [10² - 10³] Pa, lesdites espèces réactives diffusant et précipitant dans la matrice métallique de la pièce pour former une sous-couche de diffusion, et
b) - on dépose sur la surface ainsi traitée une couche de carbone en phase vapeur sous plasma électrique, dans la même enceinte, en modifiant graduellement la composition de l'atmosphère du traitement préalable, d'une part par introduction d'un hydrocarbure et/ou d'un silane à l'état gazeux et d'autre part par réduction progressive des pressions partielles des espèces réactives utilisées lors du traitement préalable, et le maintien de l'atmosphère d'hydrocarbure pour le dépôt de carbone, ce qui engendre la formation successive d'une couche de transition et d'une couche de carbone, l'atmosphère de l'enceinte utilisée pour l'opération de dépôt de carbone étant composée d'au moins un gaz choisi parmi les hydrocarbures aliphatiques, les hydrocarbures aromatiques, les cyclanes, et les silanes, la température utilisée pour le dépôt de carbone étant comprise dans l'intervalle [-200 + 400]° C, la couche de carbone étant réalisée dans une enceinte dont l'atmosphère est à une pression comprise dans l'intervalle (10⁻² - 10⁺⁴] Pa.

Les autres caractéristiques de l'invention sont :
- il est possible d'introduire également un silane dans l'atmosphère de l'enceinte lors du traitement préalable.
- La température du traitement préalable est comprise de préférence dans l'intervalle [350 - 600]°C.
- Le traitement préalable est réalisé dans une enceinte pouvant contenir partiellement un gaz inerte.
- Les hydrocarbures aliphatiques utilisables pour l'opération de dépôt de carbone peuvent être notamment des alcanes, alcènes, alcynes.
- L'atmosphère de l'enceinte pour le dépôt de carbone est composée de préférence d'au moins un gaz choisi parmi CH₄, C₃H₈ et C₆H₆, et peut comprendre, en outre, de l'hydrogène moléculaire.
- La température utilisée pour le dépôt du carbone est comprise de préférence dans l'intervalle [0 - 400]°C.
- La couche de carbone est réalisée dans une enceinte dont l'atmosphère est à une pression comprise de préférence dans l'intervalle [10² - 10³] Pa.
- Il est réalisé successivement une sous-couche de diffusion, une couche de transition et une couche de carbone assurant une croissance progressive de la dureté, du métal vers la couche de carbone.
- La coloration conférée à la pièce traitée est un moyen visuel de la qualité du traitement préalable et de la couche de carbone.

La description qui suit et les dessins annexés, le tout donné à titre indicatif, fera bien comprendre l'invention.

La figure 1 présente un schéma d'une pièce vue en coupe et sur laquelle a été réalisé le dépôt d'une couche de carbone I-C selon l'invention.

La figure 2 montre les courbes de l'évolution de la microdureté superficielle Knoop respectivement à une pièce en acier 35CD4 non traitée, pour une pièce en acier 35CD4 soumise à un simple traitement de nitruration ionique et pour une pièce du même acier comportant une couche de carbone dur I-C selon le procédé de l'invention.

La figure 3 présente les courbes de l'évolution du coefficient de frottement en fonction du temps pour une pièce comportant un prétraitement de nitruration ionique et pour une pièce comportant en sus une couche de carbone dur I-C obtenu selon le procédé de l'invention.

La figure 4 présente les courbes de mesures potentio-cinétiques obtenues dans une solution 1N d'acide sulfurique désaérée à 25°C, avec une pièce en acier 35CD4 non traitée, et avec une pièce comportant le prétraitement de nitruration ionique et revêtue de carbone I-C selon le procédé de l'invention.

La figure 5 montre des courbes de test de potentiel de piqûre obtenues dans une solution de NaCl à 30 g/l aérée à 25°C pour une pièce en acier 35CD4 soumise à un prétraitement de nitruration ionique et pour une pièce revêtue de carbone I-C selon le procédé de l'invention.

Le procédé de traitement superficiel d'une pièce métallique selon l'invention est mis en oeuvre de façon à soumettre la surface de celle-ci à un traitement thermochimique préalable, comme par exemple une nitruration ionique, suivi d'un dépôt chimique d'une couche de carbone sous plasma électrique.

Bien que le carbone soit connu pour ses propriétés tribologiques remarquables et son inertie chimique très élevée, il s'avère que ce matériau n'est pas adhérent lorsqu'il est déposé en couche mince directement sur une surface métallique non traitée.

Selon l'invention on soumet une surface de la pièce à un traitement thermochimique préalable dans une atmosphère contenant des espèces réactives générées par l'action d'un plasma électrique sur des gaz du type CH₄, N₂, C₃H₈, H₂S et de l'hydrogène.

Sous l'effet du champ électrique régnant au voisinage de la pièce, les ions plasmatiques créés sont accélérés à la surface de la pièce et provoquent:
- un chauffage de la pièce par dissipation de l'énergie cinétique en énergie calorifique,
- un décapage de la surface de la pièce par un phénomène de pulvérisation cathodique,
- une diffusion à l'état solide des atomes incidents, par exemple d'azote, qui se placent en position interstitielle dans le réseau cristallin de la matrice métallique et participent à la précipitation de composés tels que des nitrures, ces deux phénomènes conduisant à un premier durcissement superficiel de la pièce prétraitée, pièce comportant une sous-couche de diffusion.

La mise en température de la pièce peut être assurée soit par le bombardement ionique seul, soit par un chauffage annexe par exemple rayonnant, soit encore par un moyen de refroidissement à circulation, lorsque l'effet du bombardement ionique seul élève la température de la pièce au-dessus de sa température de traitement.

Selon l'invention, après traitement préalable, on dépose sur la surface prétraitée une couche de carbone (par exemple dur amorphe dit carbone I-C) réalisée dans la même enceinte, en modifiant progressivement la composition de l'atmosphère gazeuse du traitement préalable, d'une part par l'introduction dans ladite enceinte d'un hydrocarbure (aliphatique ou aromatique) et, d'autre part, par la réduction progressive de la quantité des espèces réactives du traitement préalable.

Les espèces réactives du traitement préalable sont progressivement remplacées par des espèces réactives générées par la décomposition des hydrocarbures dans le plasma électrique, ce qui engendre la formation d'une couche de transition et d'une couche de carbone, dans les conditions de température et de pression ajustées pour le dépôt dudit carbone.

Le procédé en continu dans une même enceinte sans remise à l'air, c'est-à-dire sans casser le vide, permet la réaction d'une couche de transition lors du passage progressif du traitement préalable au dépôt de carbone, couche de transition qui comporte, vers la surface de la couche de carbone, un gradient croissant en concentration de carbone.

Dans un exemple de réalisation selon l'invention, une pièce d'acier du type 35CD4 est soumise à un traitement thermochimique préalable dans une atmosphère réactive composée d'un mélange gazeux d'azote de d'hydrogène contenant environ 12% de N₂. On crée dans l'enceinte à la pression de 400 Pa un plasma électrique en polarisant la pièce à un potentiel de -600 volts et on régule la température de la pièce à 500°C pendant une durée de traitement préalable d'environ 2 heures.

Un tel traitement préalable permet la réalisation d'une nitruration générant un durcissement superficiel de la surface de la pièce par un phénomène de diffusion à l'état solide et de précipitation sous la forme de nitrure et/ou de carbonitrure de certains éléments contenus dans l'acier, avec formation d'une couche superficielle de nitrure et/ou de carbonitrure, dite couche de combinaison. Il est possible, dans une autre forme de réalisation et d'autres conditions, de réaliser une diffusion d'azote sans la formation d'une couche superficielle dite de combinaison.

Ensuite, le dépôt de carbone est réalisé dans l'enceinte dont l'atmosphère, à la pression de 100 Pa, comprend 10% de CH₄. Il est possible d'ajouter un gaz neutre tel que l'hélium afin d'augmenter la cinétique de dépôt. La température de dépôt est, pour la couche de carbone, fixée à 160°C. Un plasma est entretenu dans ces conditions en maintenant la pièce sous une tension de -700 volts.

Le procédé est remarquable en ce que l'on combine, dans une même enceinte, des conditions de traitement de surface comme la nitruration ionique et des conditions de dépôt assisté par plasma d'une couche de carbone dur amorphe, c'est-à-dire des conditions de température de pression et d'atmosphère qui sont très différentes les unes des autres.

Les conditions selon l'invention sont choisies de façon à permettre d'effectuer la totalité des opérations du procédé en continu sous un plasma électrique, les conditions respectives du prétraitement et du dépôt de carbone étant différentes.

L'atmosphère permettant le dépôt de carbone peut contenir en outre de l'hydrogène moléculaire dans une proportion comprise dans un intervalle de [1 à 50]%. La couche de carbone réalisée est alors une couche de carbone hydrogénée dont la concentration en hydrogène est supérieure à 1%.

Afin d'assurer de bonnes propriétés tribologiques à la pièce traitée, on réalise successivement un traitement préalable, une couche de transition et une couche de carbone assurant une variation de dureté croissante du niveau de dureté de la pièce jusqu'au niveau de dureté de la couche de carbone.

Le procédé selon l'invention assure, par la succession d'un prétraitement et de la croissance en continu de la couche de carbone une bonne adhésion de ladite couche sur la surface de la pièce métallique.

Le procédé selon l'invention permet l'obtenion d'une coloration marquée de la surface de la pièce traitée, coloration esthétique, du type noire bleutée pour une pièce en acier. Cette coloration permet d'une part un contrôle de la qualité de la couche déposée et du traitement préalable du point de vue de son homogénéité, et d'autre part, après usage de la pièce, une détermination du niveau d'usure de celle-ci par le changement de coloration.

les figures annexées représentent des résultats de caractérisation de pièces traitées selon le procédé.

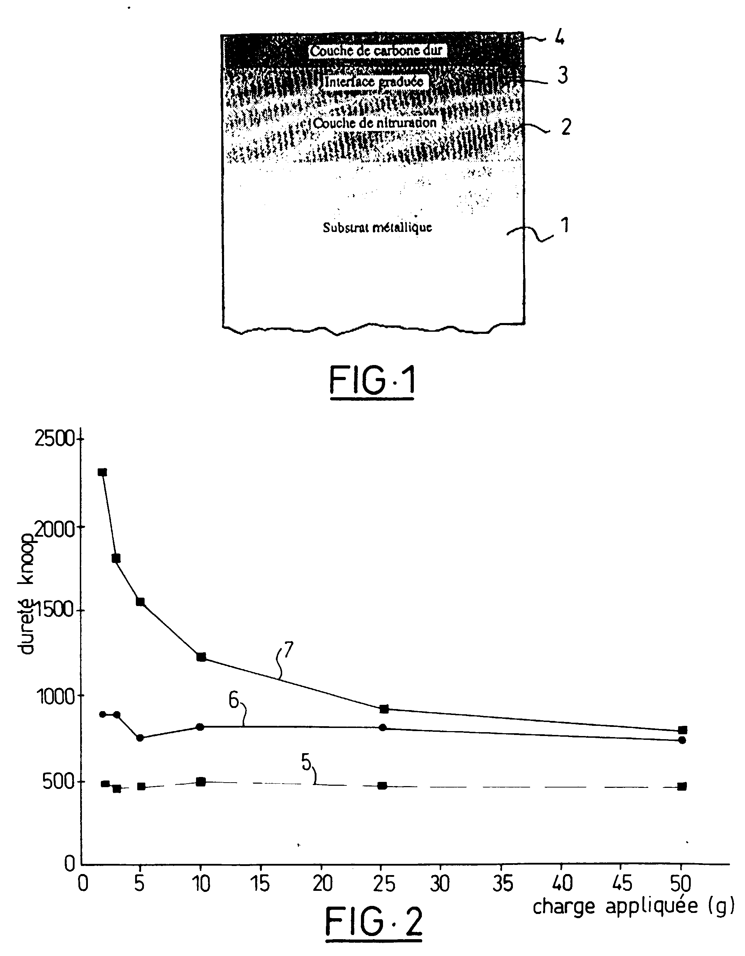

La figure 1 est un schéma d'une pièce en coupe comportant une couche de carbone réalisée selon l'invention. La pièce métallique 1 a été soumise à un prétraitement formant la sous-couche de diffusion 2 (ici couche de nitruration). Lors de la modification graduelle de la composition -notamment de l'atmosphère- du traitement préalable pour la formation de la couche de carbone, il est réalisé une couche de transition 3 formant une interface graduée avant la croissance de la couche 4 de carbone dur I-C .

La figure 2 présente les courbes de l'évolution de la microdureté superficielle Knoop (HK) en fonction de la charge appliquée (g) pour une pièce en acier 35CD4. La courbe 5 correspond au test en microdureté de la pièce sans traitement, la courbe 6 correspond à la pièce ayant subi un prétraitement (nitruration 2h, 520°C) et la courbe 7 correspond à la pièce avec le dépôt de carbone (4h, 160°C) après le même prétraitement.

Le prétraitement de nitruration ionique conduit à un premier durcissement superficiel important de la pièce. Par exemple dans les conditions de prétraitement choisies, le niveau de microdureté de la pièce, mesuré sous une charge de 50 g, passe approximativement de 500 à 750 HK. Le dépôt de I-C conduit à un accroissement supplémentaire de la microdureté superficielle de la pièce encore beaucoup plus important. La microdureté superficielle atteint, sous une charge appliquée de 2 g, 2300 HK pour les conditions de traitement choisies.

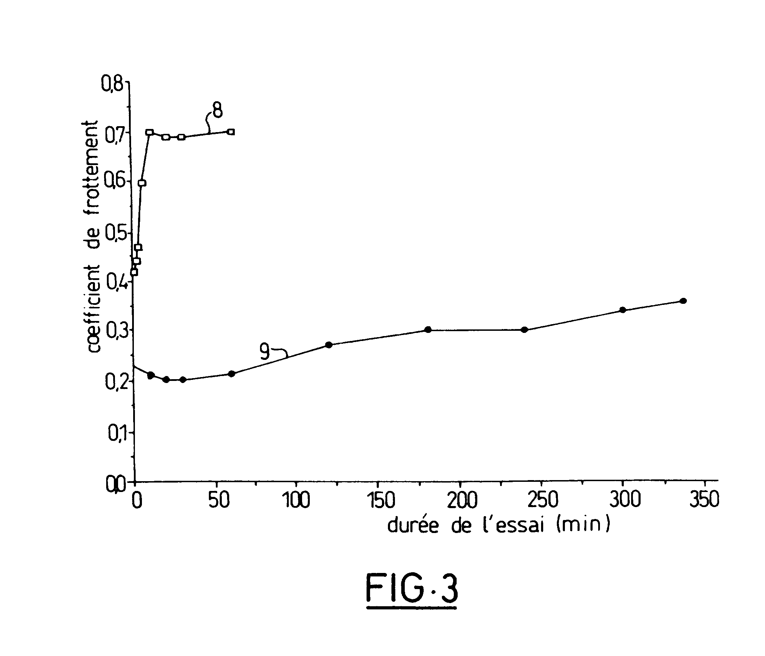

La figure 3 présente les courbes d'évolution du coefficient de frottement en fonction du temps. La courbe 8 représente le coefficient de frottement d'une pièce sur laquelle a été réalisée le prétraitement seulement et la courbe 9 représente le coefficient de frottement de la pièce sur laquelle a été réalisée la couche de carbone après le même prétraitement.

Le comportement tribologique de la pièce revêtue selon le procédé décrit dans la présente invention a été testé au moyen d'essais réalisés sur un tribomètre du type bille-disque. Dans cet essai la pièce à tester est un disque de diamètre égal à 45 mm, mis en rotation à une vitesse préalablement choisie et sur lequel on vient appliquer, avec une charge normale connue et préalablement choisie, une bille fixe constituée par un matériau de référence, comme par exemple un acier du type 100 C6. Cet essai permet de mesurer le coefficient de frottement en fonction du temps dans des conditions de vitesses de glissement et de charge normale bien définies et permet également de mesurer l'usure en fonction de la durée de l'essai soit par analyse profilométrique de la trace d'usure, soit par la mesure de la perte de poids de la pièce testée.

Cette figure 3 met en évidence l'effet bénéfique du dépôt de carbone I-C qui provoque une forte diminution de la valeur du coefficient de frottement, le coefficient étant de 0,7 environ pour la pièce ayant subi le prétraitement de nitruration ionique et seulement de 0,2 pour celle ayant également reçu le dépôt de I-C, après 25 min d'essai.

Le coefficient de frottement pour la pièce avec dépôt de carbone I-C évolue lentement dans le temps. Par ailleurs, aucune usure appréciable n'a pu être décélée après 325 min d'essai dans le cas de la pièce revêtue de I-C, tandis que des traces d'usure de profondeur maximale égale environ à 1 µm ont pu être mises en évidence après seulement 50 min d'essai dans le cas de la pièce avec prétraitement de nitruration ionique seulement.

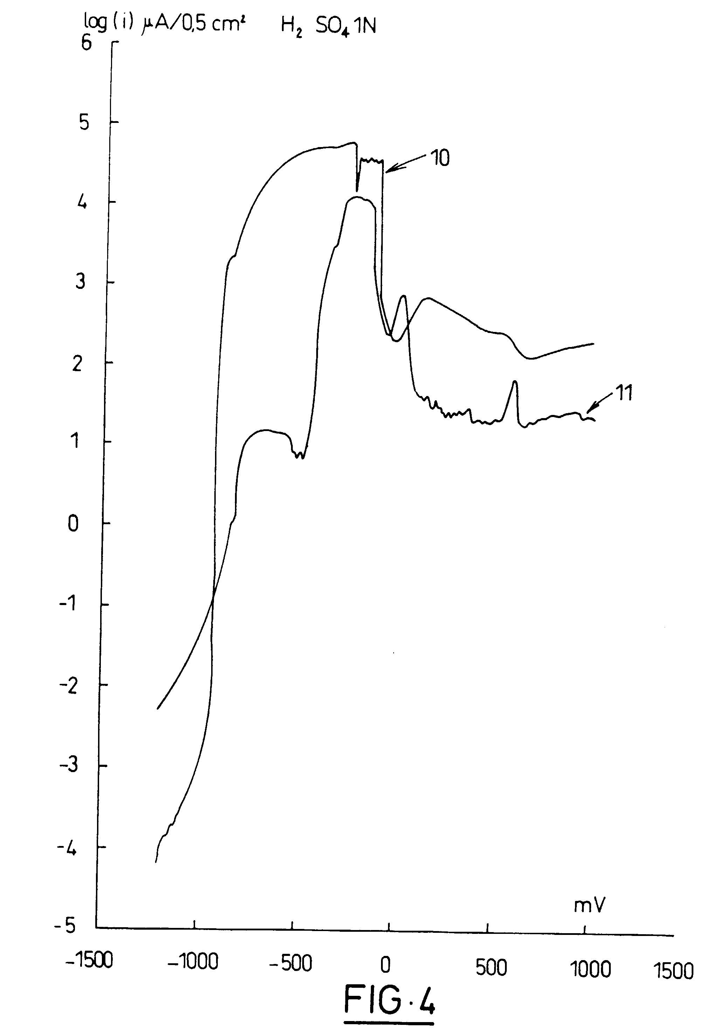

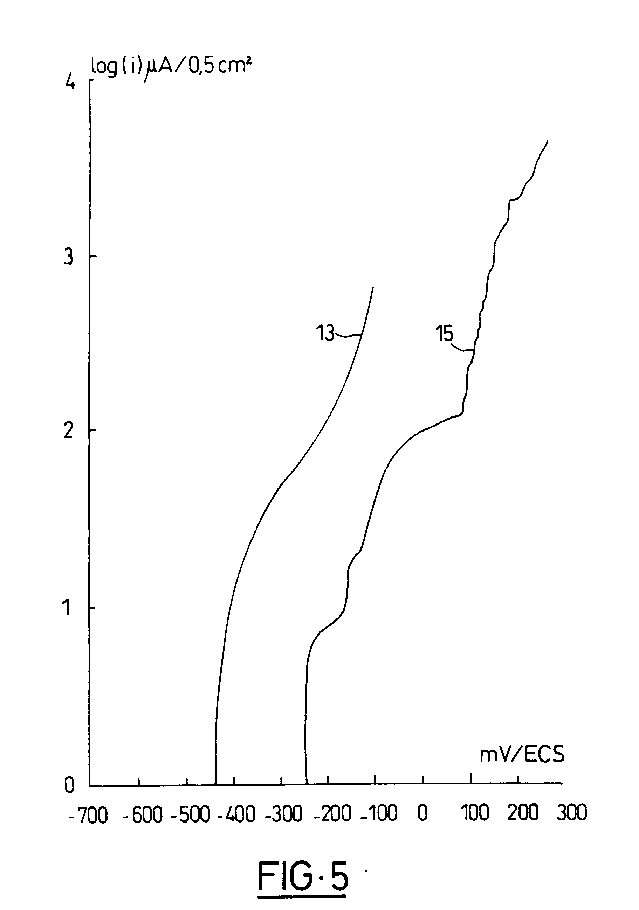

Les figures 4 et 5 représentent des courbes caractéristiques de tests potentio-cinétiques réalisés respectivement dans une solution 1N d'acide sulfurique désaérée par barbotage d'argon à 25°C et dans une solution chlorurée neutre NaCl à 30 g/l aérée et 25°C, d'une part sur une pièce en acier 35 CD4 prétraitée et d'autre part sur une même pièce prétraitée et revêtue de carbone dur I-C.

Les tests potentio-cinétiques consistent à déterminer la variation de l'intensité du courant qui circule entre la pièce à étudier et une électrode dite contre-électrode (généralement une électrode de platine) en fonction du potentiel électrique imposé à la pièce à étudier, repéré par rapport à une électrode dite de référence (généralement une électrode au calomel saturé désigné ECS sur la figure).

Le potentiel imposé à la pièce est fourni par un potentiostat. Celui-ci varie linéairement en fonction du temps, selon une vitesse préalablement choisie. Au commencement du test la pièce est le siège d'une réaction cathodique; à potentiel plus élevé, la surface de la pièce subit des réactions d'oxydation avec mise en solution du métal constitutif.

On trace ainsi une courbe densité de courant (i) en fonction du potentiel appliqué (vitesse de balayage : 900 mV/h), dont l'examen donne un grand nombre de renseignements sur le comportement de la pièce dans le milieu agressif choisi, en particulier en ce qui concerne son aptitude à la passivation ou à la corrosion par piqûre.

La solution d'acide sulfurique (fig. 4) conduit généralement à une corrosion de type uniforme dans le cas des aciers, tandis que la solution chlorure (fig. 5) provoque, dans le cas des aciers inoxydables, une corrosion localisée par piqûres.

Les courbes potentio-cinétiques de la figure 4 obtenues en solution sulfurique pour une pièce constituée par un acier 35CD4 montrent que le dépôt de I-C réalisé par le procédé selon la présente invention (courbe 11) conduit à une forte réduction du pic d'activité ainsi que du courant de passivation 11, en comparaison d'une pièce soumise à un prétraitement de nitruration ionique seul (courbe 10).

Les courbes potentio-cinétiques de la figure 5 obtenues en solution chlorurée neutre pour une pièce constituée par un acier 35CD4 nitruré (courbe 13) et une pièce revêtue de carbone I-C réalisée selon le procédé décrit dans la présente invention (courbe 15) montrent que le procédé conduit à une forte augmentation du potentiel de piqûre de carbone dans le cas du dépôt de carbone I-C. Par ailleurs on note l'existence d'un domaine de passivité dans le cas de la pièce revêtue du carbone I-C.

## Revendications

1. Procédé de traitement pour déposer une couche de carbone, en phase vapeur, dans une enceinte, sur la face d'une pièce métallique pour conférer à cette pièce une résistance à l'usure par frottement, une résistance à la corrosion, ainsi qu'une coloration, caractérisé en ce que
a) - on soumet la surface de la pièce à un traitement préalable thermochimique sous plasma électrique dans l'enceinte sous atmosphère contenant de l'hydrogène et au moins une espèce réactive choisie parmi N₂, CH₄, C₃H₈ et H₂S, à une température comprise dans l'intervalle [350 - 900]° C, la pression de l'atmosphère de l'enceinte étant comprise dans un intervalle de [10² - 10³] Pa, lesdites espèces réactives diffusant et précipitant dans la matrice métallique de la pièce pour former une sous-couche de diffusion, et
b) - on dépose sur la surface ainsi traitée une couche de carbone en phase vapeur sous plasma électrique, dans la méme enceinte, en modifiant graduellement la composition de l'atmosphère du traitement préalable, d'une part par introduction d'un hydrocarbure et/ou d'un silane à l'état gazeux et d'autre part par réduction progressive des pressions partielles des espèces réactives utilisées lors du traitement préalable, et le maintien de l'atmosphère d'hydrocarbure pour le dépôt de carbone, ce qui engendre la formation successive d'une couche de transition et d'une couche de carbone, l'atmosphère de l'enceinte utilisée pour l'opération de dépôt de carbone étant composée d'au moins un gaz choisi parmi les hydrocarbures aliphatiques, les hydrocarbures aromatiques, les cyclanes, et les silanes, la température utilisée pour le dépôt de carbone étant comprise dans l'intervalle [-200, + 400]° C, la couche de carbone étant réalisée dans une enceinte dont l'atmosphère est à une pression comprise dans l'intervalle [10⁻² - 10⁺⁴] Pa.

2. Procédé selon la revendication 1, caractérisé en ce que l'on introduit, en outre, un silane dans l'atmosphère du traitement préalable.

3. Procédé selon la revendication 1 ou 2, caractérisé en ce que la température du traitement préalable est comprise dans l'intervalle [350 - 600]° C.

4. Procédé selon la revendication 1, caractérisé en ce que le traitement préalable est réalisé dans une enceinte pouvant contenir partiellement un gaz inerte.

5. Procédé selon l'une des revendications 1 à 4, caractérisé en ce que l'atmosphère de l'enceinte utilisée pour l'opération de dépôt de carbone est composée d'au moins un gaz choisi parmi CH₄, C₃H₈, C₆H₆.

6. Procédé selon l'une des revendications 1 à 5, caractérisé en ce que l'atmosphère de l'enceinte, utilisée pour l'opération de dépôt de carbone, comprend en outre de l'hydrogène moléculaire.

7. Procédé selon la revendication 1, caractérisé en ce que la température utilisée pour le dépôt de carbone est comprise dans l'intervalle [0 - 400]° C.

8. Procédé selon la revendication 1, caractérisé en ce que la pression pour l'opération de dépôt de carbone est comprise dans l'intervalle [10¹ - 10³] Pa.

9. Procédé selon l'une des revendications 1 à 8, caractérisé en ce qu'on introduit dans la couche de carbone de l'hydrogène dans une proportion de 1 à 50 %.

10. Procédé selon l'une des revendications 1 à 9, caractérisé en ce qu'il est réalisé successivement une sous-couche de diffusion, une couche de transition et une couche de carbone assurant, du métal vers la couche de carbone, une croissance progressive de la dureté.

11. Procédé selon l'une des revendications 1 à 10, caractérisé en ce que le coloration est un moyen visuel de la qualité du traitement préalable et de la couche de carbone.

## Patentansprüche

1. Behandlungsverfahren zur Dampfabscheidung einer Kohlenstoffschicht in einer Kammer auf die Oberfläche eines Metallwerkstücks, um diesem Werkstück eine Abriebfestigkeit, eine Korrosionsbeständigkeit sowie eine Färbung zu verleihen, dadurch gekennzeichnet, daß
a) - die Oberfläche des Werkstücks einer thermochemischen Vorbehandlung unter elektrischem Plasma in einer Kammer unter einer Atmosphäre, die Wasserstoff und mindestens eine reaktive Spezies, ausgewählt unter N₂, CH₄, C₃H₈ und H₂S, enthält, bei einer Temperatur im Bereich [350 - 900]°C unterzogen wird, wobei der Druck der Atmosphäre der Kammer in einem Bereich von [10² - 10³] Pa liegt, wobei die reaktiven Spezies in die metallische Matrix des Werkstücks diffundieren und sich dort niederschlagen, um einen Diffusionsuntergrund zu bilden, und
b) - auf die so behandelte Oberfläche in derselben Kammer unter elektrischem Plasma eine Kohlenstoffschicht dampfabgeschieden wird, indem die Zusammensetzung der Atmosphäre der Vorbehandlung einerseits durch die Einleitung eines Kohlenwasserstoffes und/oder eines Silans im gasförmigen Zustand und andererseits durch die fortschreitende Verringerung der Partialdrücke der bei der Vorbehandlung verwendeten reaktiven Spezies und die Aufrechterhaltung der Kohlenwasserstoffatmosphäre für die Kohlenstoffabscheidung allmählich verändert wird, was die aufeinanderfolgende Bildung einer Übergangsschicht und einer Kohlenstoffschicht zur Folge hat, wobei sich die Atmosphäre der für den Arbeitsgang der Kohlenstoffabscheidung verwendeten Kammer aus mindestens einem Gas, gewählt unter den aliphatischen Kohlenwasserstoffen, den aromatischen Kohlenwasserstoffen, den Cyclanen und den Silanen, zusammensetzt, die für die Kohlenstoffabscheidung verwendete Temperatur im Bereich [-200, +400]°C liegt und die Kohlenstoffschicht in einer Kammer geschaffen wird, deren Atmosphäre einen Druck im Bereich [10⁻² - 10⁺⁴] Pa aufweist.

2. Verfahren nach Anspruch 1, dadurch gekennzeichnet, daß außerdem ein Silan in die Atmosphäre der Vorbehandlung eingeleitet wird.

3. Verfahren nach Anspruch 1 oder 2, dadurch gekennzeichnet, daß die Temperatur der Vorbehandlung im Bereich [350 - 600]°C liegt.

4. Verfahren nach Anspruch 1, dadurch gekennzeichnet, daß die Vorbehandlung in einer Kammer durchgeführt wird, die teilweise ein inertes Gas enthalten kann.

5. Verfahren nach einem der Ansprüche 1 bis 4, dadurch gekennzeichnet, daß sich die Atmosphäre der für den Arbeitsgang der Kohlenstoffabscheidung verwendeten Kammer aus mindestens einem Gas, gewählt unter CH₄, C₃H₈, C₆H₆, zusammensetzt.

6. Verfahren nach einem der Ansprüche 1 bis 5, dadurch gekennzeichnet, daß die Atmosphäre der für den Arbeitsgang der Kohlenstoffabscheidung verwendeten Kammer außerdem molekularen Wasserstoff enthält.

7. Verfahren nach Anspruch 1, dadurch gekennzeichnet, daß die für die Kohlenstoffabscheidung verwendete Temperatur im Bereich [0 - 400]°C liegt.

8. Verfahren nach Anspruch 1, dadurch gekennzeichnet, daß der Druck für den Arbeitsgang der Kohlenstoffabscheidung im Bereich [10¹ - 10³] Pa liegt.

9. Verfahren nach einem der Ansprüche 1 bis 8, dadurch gekennzeichnet, daß in die Kohlenstoffschicht Wasserstoff in einem Verhältnis von 1 bis 50% eingeführt wird.

10. Verfahren nach einem der Ansprüche 1 bis 9, dadurch gekennzeichnet, daß aufeinanderfolgend ein Diffusionsuntergrund, eine Übergangsschicht und eine Kohlenstoffschicht gebildet werden, wodurch vom Metall zur Kohlenstoffschicht hin ein fortschreitendes Anwachsen der Härte gewährleistet wird.

11. Verfahren nach einem der Ansprüche 1 bis 10, dadurch gekennzeichnet, daß die Färbung ein visuelles Mittel für die Qualität der Vorbehandlung und der Kohlenstoffschicht ist.

## Claims

1. Treatment procedure to deposit a layer of carbon, in a vapour phase, in a tank, on the face of a metallic part, to give this part resistance to wear by friction, resistance to corrosion as well as colouring in that:
a) the surface of the part is subjected in advance to thermal chemical treatment under electric plasma in a tank in an atmosphere containing hydrogen and at least one reactive sort chosen from N2, CH4, C3H8, and H2S at a temperature in the interval [350 - 900] oC, the pressure of the atmosphere in the tank being within an interval of [10² - 10³] Pa; the said reactive sorts being diffused and precipitated in the metallic matrix of the part to form a diffusion sub-layer, and,
b) a layer of carbon is placed on the surface, which has been treated thus, in a vapour phase under electric plasma, in the same tank, by gradually modifying the composition of the atmosphere of the preliminary treatment, on one hand by introducing hydrocarbon and/or a silane in a gaseous state and on the other hand by the progressive reduction of the partial pressures of the reactive sorts used during the preliminary treatment, and maintaining the hydrocarbon atmosphere for the carbon deposit which brings about the successive formation of a transition layer and a carbon layer, the atmosphere in the tanks used for the carbon deposit operation being comprised at least from a gas chosen from aliphatic hydrocarbons, aromatic hydrocarbons, cyclanes, silanes, the temperature used for the carbon deposit being in the interval [-200, +400]oC, the carbon layer being made in a tank whose atmosphere has a pressure in the interval [10⁻² - 10⁺⁴] Pa.

2. Procedure according to claim 1, characterised by the fact that a silane is introduced into the atmosphere of the preliminary treatment.

3. Procedure according to claim 1 or 2, characterised by the fact that the temperature of the preliminary treatment is in the interval [350 - 600]°C.

4. Procedure according to claim 1, characterised by the fact that the preliminary treatment is carried out in a tank which can partially contain an inert gas.

5. Procedure according to one of claims 1 to 4, characterised by the fact that the atmosphere in the tank used for the carbon deposit operation comprises at least one gas chosen from CH4, C3H8, C6H6.

6. Procedure according to one of claims 1 to 5 characterised by the fact that the atmosphere in the tank used for the carbon deposit operation, also comprises molecular hydrogen.

7. Procedure according to claim 1, characterised by the fact that the temperature used for the carbon deposit is in the interval [0 - 400]°C.

8. Procedure according to claim 1, characterised by the fact that the pressure for the carbon deposit operation is in the interval [10¹ - 10³]Pa.

9. Procedure according to one of claims 1 to 8, characterised by the fact that hydrogen is introduced into the carbon layer in a proportion of 1 to 50%.

10. Procedure according to one of claims 1 to 9, characterised by the fact that a diffusion sub-layer, a transition layer and a carbon layer are made successively, guarantecing, from the metal to the carbon layer, a progressive increase in hardness.

11. Procedure according to one of claims 1 to 10, characterised by the fact that the coloration is a visual means of the quality of the preliminary treatment and the carbon layer.
